# EUROPÄISCHE PATENTANMELDUNG

(11) **EP 1 705 492 A1**
(43) Veröffentlichungstag der Anmeldung: **27.09.2006**
(21) Anmeldenummer: 05006652.1
(22) Anmeldetag: 24.03.2005
(51) Int. Cl.: G01R 31/34, H02K 15/02

(54) **Messverfahren, -vorrichtung und -system zur Charakterisierung von Schwingungsanregungen eines Turbogenerator-Ständerteils**

(71) Anmelder: SIEMENS AKTIENGESELLSCHAFT, 80333 München (DE)
(72) Erfinder: Haschke, Peter, 46149 Oberhausen (DE); Richter, Claus-Georg, 45468 Mülheim an der Ruhr (DE); Sommer, Fritz, 45481 Mülheim an der Ruhr (DE); Twellmann, Hans-Bernd, 45473 Mülheim an der Ruhr (DE); Will, Manfred, 45479 Mülheim an der Ruhr (DE)

(57) **Zusammenfassung**

Um eine messtechnische Ermittlung eines Frequenzgangs des Schwingungsverhaltens eines Turbogenerator-Ständerteils sowohl in einem weiten Frequenzbereich als auch im Hinblick auf schwache Frequenzanteile möglich zu machen, sieht ein Messverfahren die Charakterisierung von Schwingungsanregungen eines Turbogenerator-Ständerteils (5) vor, das einen Gehäusemantel (9) und ein in dem Gehäusemantel (9) angeordnetes Ständeraktivteil (11) aufweist, das einen ferromagnetischen Hohlkörper (15) bildet. Gemäß dem neuen Konzept wird der ferromagnetische Hohlkörper (15) durch ein Magnetfeld schwingungsangeregt und eine Amplitude einer Schwingungsanregung wird am Gehäusemantel (9) gemessen.

## Beschreibung

Die Erfindung betrifft ein Messverfahren zur Charakterisierung von Schwingungsanregungen eines Turbogenerator-Ständerteils, aufweisend einen Gehäusemantel und ein in dem Gehäusemantel angeordnetes Ständeraktivteil, das einen ferromagnetischen Hohlkörper bildet. Die Erfindung betrifft weiter eine entsprechende Messvorrichtung sowie ein Messsystem zur Charakterisierung von Schwingungsanregungen aufweisend eine Messvorrichtung und ein Turbogenerator-Ständerteil, aufweisend einen Gehäusemantel und ein in dem Gehäusemantel angeordnetes Ständeraktivteil, das einen ferromagnetischen Hohlkörper bildet.

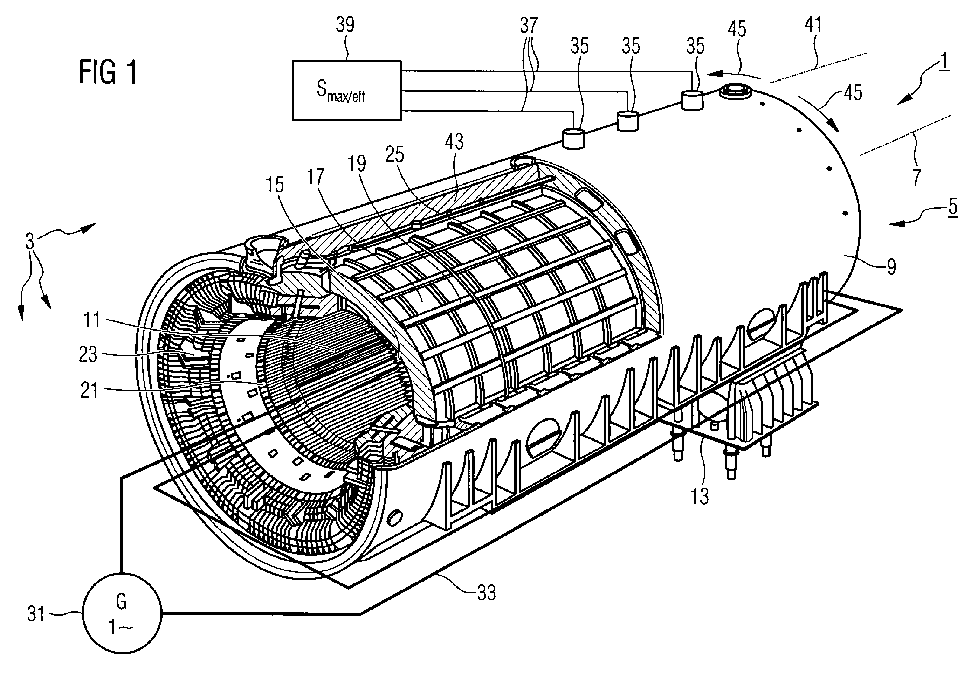

Ein Turbogenerator weist in der Regel einen Läufer mit einer Läuferwicklung auf, der innerhalb eines Turbogenerator-Ständerteils angeordnet ist. Das Turbogenerator-Ständerteil weist einen Gehäusemantel und ein in dem Gehäusemantel angeordnetes Ständeraktivteil auf, das einen ferromagnetischen Hohlkörper bildet. Dieser ist in der Regel durch das so genannte Ständerblechpaket gebildet. Im Einzelnen wird der Aufbau eines Turbogenerator-Ständerteils in Bezug auf die FIG 1 erläutert.

Ein Turbogenerator-Ständerteil zeigt im Betrieb grundsätzlich mechanische Schwingungen, die dadurch entstehen, dass Schwingungen des Ständeraktivteils an das in der Regel mechanisch mit dem Ständeraktivteil gekoppelte Gehäuse bzw. den Gehäusemantel übertragen werden. Schwingungen des Ständeraktivteils können insbesondere durch eine Überlagerung harmonischer Oberwellen einer Ständer- und Läuferwicklung entstehen. Weist in einem ungünstigen Fall das Gehäuse konstruktions- und fertigungsbedingt eine schwach gedämpfte Eigenfrequenz nahe der anregenden Frequenz des Ständeraktivteils auf, so können die Teile des Gehäuses, ähnlich wie die Membran eines Lautsprechers, zu einer stark erhöhten mechanischen Schwingung angeregt werden. Dies kann zu einer erheblichen Geräusch- und Betriebsemission führen. Es hat sich gezeigt, dass solche Geräuschemissionen weit oberhalb von 85 dB liegen können. Um eine bedarfsgerechte Dämpfung dieser Schwingungen vornehmen zu können, ist es notwendig, die Schwingungsanregungen eines Turbogenerator-Ständerteils, insbesondere des Gehäuses, möglichst genau zu charakterisieren.

Bekannt ist die Bestimmung von Eigenfrequenzen durch eine so genannte "Hammerschlag-Impuls"-Messung. Dabei wird das Gehäuse durch einen hammerschlagartigen mechanischen Impuls angeregt und es wird eine Messung der angeregten Schwingungen als Antwort auf den mechanischen Impuls durchgeführt. Eine solche Methode kommt jedoch bei Prüflingen großer Abmessungen und Masse, wie dies der Fall eines Turbogenerator-Ständerteils ist, an ihre Grenzen. Dies beruht vor allem darauf, dass die Impulsgröße des hammerschlagartigen mechanischen Impulses begrenzt ist, d. h. der einem Gehäuse zuführbare Kraftstoß ist in seiner Stärke nicht beliebig erhöhbar. Dies führt dazu, dass eine Schwingungsanregung, die bei einem betriebsähnlichen Zustand auftreten kann, nicht mehr durch den Kraftstoß angeregt werden kann und somit auch nicht mehr gemessen werden kann. In der Regel wird nämlich die Energie der impulsartigen Anregungen auf die Eigenfrequenzen der Schwingungsanregungen des Turbogenerator-Ständerteils übertragen und vor allem durch die Eigenmoden dissipiert. Dies führt dazu, dass üblicherweise schwache Frequenzen nicht mehr erkennbar sind und höhere Frequenzen amplitudenschwach sind. Dies trifft insbesondere für Frequenzen oberhalb von 100 Hz zu. Eine gezielte und isolierte Anregung einzelner Frequenzen ist nicht möglich.

Wünschenswert wäre es, die Schwingungsanregungen eines Turbogenerator-Ständerteils auch für Frequenzen weit oberhalb von 100 Hz und hinsichtlich weiterer Parameter charakterisieren zu können.

An dieser Stelle setzt die Erfindung an, deren Aufgabe es ist, ein Messverfahren und eine Vorrichtung zur Charakterisierung von Schwingungsanregungen eines Turbogenerator-Ständerteils anzugeben, die gewährleisten, dass die Schwingungsanregungen eines Turbogenerator-Ständerteils genauer und in größerem Umfang als bisher charakterisiert werden können.

Hinsichtlich des Messverfahrens wird die Aufgabe mit einem Messverfahren der eingangs genannten Art gelöst, bei dem der ferromagnetische Hohlkörper durch ein Magnetfeld schwingungsangeregt wird, und eine Amplitude einer Schwingungsanregung am Gehäuse gemessen wird.

Die Erfindung geht dabei von der Überlegung aus, dass die bisher favorisierte Hammerschlag-Impuls-Methode einen betriebsähnlichen Zustand hinsichtlich der Charakterisierung von Schwingungsanregungen nur ungenügend wiedergibt. Die Erfindung hat erkannt, dass für eine genaue und weitergehende Charakterisierung von Schwingungsanregungen eines Turbogenerator-Ständerteils eine möglichst umfassende Anregung desselben erfolgen sollte. Dies wird gemäß der Erfindung dadurch erreicht, dass der ferromagnetische Hohlkörper durch ein Magnetfeld schwingungsangeregt wird. Dies garantiert nämlich zunächst die komplette Anregung des ferromagnetischen Hohlkörpers, wohingegen die Hammerschlag-Impuls-Methode lediglich eine örtlich begrenzte Anregung bewerkstelligen konnte. Darüber hinaus bietet das erfindungsgemäße Konzept den Vorteil, dass verschiedenste Parameter zur Variation zur Verfügung gestellt werden und, ggf. in Abhängigkeit dieser Parameter, eine Amplitude einer Schwingungsanregung am Gehäuse gemessen werden kann. Es hat sich herausgestellt, dass mit einer magnetischen Schwingungsanregung des ferromagnetischen Hohlkörpers nicht nur eine Anregung in einem weiten Frequenzbereich möglich ist, sondern darüber hinaus neben den Eigenfrequenzen auch weniger stark ausgeprägte Frequenzen am Gehäuse gemessen werden können. Bei geeigneter Durchführung des Verfahrens können nämlich verschiedene Frequenzen in einem weiten Spektrum von Anregungsfrequenzen nacheinander "durchfahren" werden.

Das Messverfahren gemäß dem neuen Konzept ermöglicht es damit, das betriebliche Verhalten bezüglich mechanischer Schwingungen sowie Geräuschemissionen im Fertigungsvorfeld eines Turbogenerators fertigungsbegleitend als qualitätssichernde Maßnahme nachzubilden. Dies wird nämlich durch die aktive magnetische Anregung des Turbogenerator-Ständerteils real, d. h. ohne Probelauf, erreicht. Bereits im Fall einer schwachen oder ungedämpften betrieblichen Resonanzanregung des Turbogenerator-Ständerteils können sofort konstruktive Abhilfemaßnahmen ergriffen werden.

Vorteilhafte Weiterbildungen der Erfindung sind den Unteransprüchen zu entnehmen und geben im Einzelnen vorteilhafte Möglichkeiten an, die wesentlichen Vorteile des Konzepts sowie weitere Vorteile zu realisieren.

In einer besonders bevorzugten Ausführungsform des Messverfahrens wird das Magnetfeld erzeugt, indem eine Erregerschleife durch den ferromagnetischen Hohlkörper hindurchgeführt wird und mit Wechselstrom beaufschlagt wird. Aufgrund des sich in der Erregerschleife ändernden Stromes wird nämlich ein dem Erregerstrom proportionaler, die Erregerschleife durchsetzender magnetischer Fluss erzeugt, der mit einem proportional zum Wechselstrom sich ändernden magnetischen Wechselfeld verbunden ist. Das magnetische Wechselfeld tritt mit dem ferromagnetischen Hohlkörper in Wechselwirkung und regt diesen zu Schwingungen an. Diese Anregung erfolgt vorteilhaft entlang der gesamten axialen Ausdehnung eines axialen ferromagnetischen Hohlkörpers und erzeugt so eine nicht nur lokale, sondern den gesamten ferromagnetischen Hohlkörper erfassende Schwingungsanregung. Dies ist wesentlich vorteilhafter als die lediglich lokale Anregung mittels der Hammerschlag-Impuls-Methode gemäß dem Stand der Technik.

Gemäß einer weiteren vorteilhaften Weiterbildung wird die Amplitude einer Schwingungsanregung gemessen, indem eine Anzahl von Schwingungsmessumformen am Gehäuse angebracht wird und ein Messsignal erzeugt, das in einem Schwingungsmessgerät aufgenommen und wiedergegeben wird. Prinzipiell kann dazu jede geeignete Art eines Schwingungsmessumformers genutzt werden. Das Schwingungsmessgerät ist vorteilhaft in der Lage, eine Amplitude der Schwingungsanregung am Gehäuse anzuzeigen und an eine Auswerteeinheit weiterzugeben.

Vorteilhaft wird das magnetische Wechselfeld frequenzvariabel bei unterschiedlichen Anregungsfrequenzen, insbesondere zwischen 300 Hz und 600 Hz erzeugt. Es hat sich nämlich gezeigt, dass insbesondere bei einem Ständeraktivteil eines wassergekühlten, vierpoligen Turbogenerators betriebsbedingt eine Frequenz im Bereich von 400 Hz angeregt wird, die zu erheblichen Betriebsgeräuschen weit oberhalb von 85 dB führt. Eine Ausmessung dieses Frequenzbereichs erweist sich als besonders vorteilhaft, um Möglichkeiten zur Dämpfung von Anregungsfrequenzen in diesem Bereich möglichst maßgenau treffen zu können. Das Magnetfeld ist dabei insbesondere stufenlos in Feldstärke/Erregung sowie Frequenz einstellbar.

In einer Auswerteeinheit oder in sonstiger Weise wird die Amplitude einer Schwingungsanregung vorteilhaft in Abhängigkeit der Anregungsfrequenz des frequenzvariablen Magnetfeldes gemessen. Auf diese Weise kann eine besonders übersichtliche und umfassende messtechnische Ermittlung des gesamten Frequenzganges des Schwingungsverhaltens des Ständeraktivteils erfolgen.

Gemäß einer besonders bevorzugten Weiterbildung des oben erläuterten Konzepts erfolgt die Charakterisierung der Schwingungsanregung frequenzabhängig am Gehäusemantel. Vorzugsweise erfolgt die Charakterisierung an ausgesuchten Punkten des Gehäuses. Insbesondere wird eine Amplitude einer Schwingungsanregung an Stellen geringer Biegesteifigkeit am Gehäuse gemessen. Derartige "weiche" Stellen sind besonders anfällig für eine durch das Ständeraktivteil erzeugte Schwingungsanregung.

In einer ganz besonders bevorzugten Weiterbildung der Erfindung wird eine räumliche Phase einer Schwingungsanregung gemessen. Wie bereits bei einer Amplitude einer Schwingungsanregung erfolgt dies vorteilhaft in Abhängigkeit der Anregungsfrequenz des frequenzvariablen Magnetfeldes. Es hat sich nämlich insbesondere für den oben erläuterten Fall eines Ständeraktivteils eines wassergekühlten Turbogenerators gezeigt, dass die mit einer Frequenz von 400 Hz angeregte Schwingung im umfänglichen Verlauf des Ständeraktivteils eine stehende Mehrknotenschwingung darstellt. Durch die Darstellung der räumlichen Phasenlage, z. B. entlang eines Umfangs des ferromagnetischen Hohlkörpers oder des Gehäuses, können also insbesondere die Knoten und Bäuche entlang der räumlichen Ausdehnung entlang des Umfangs ermittelt werden. Insbesondere in Bauchbereichen der Schwingungsanregung lassen sich dann aufgrund der Messergebnisse maßgeschneiderte Dämpfungsmaßnahmen anbringen.

Hinsichtlich der Vorrichtung wird die Aufgabe der vorliegenden Erfindung durch eine Messvorrichtung der eingangs genannten Art gelöst, die erfindungsgemäß aufweist:
- einen Strom- und/oder Spannungsgenerator;
- eine an den Strom- und/oder Spannungsgenerator anschließbare Erregerschleife zur Beaufschlagung mit Wechselstrom und/oder Wechselspannung durch den Strom- und/oder Spannungsgenerator;
- einen Schwingungsmessumformer aufweisend einen Sensor zur Aufnahme einer Schwingungsanregung und Mittel zur Umformung der Schwingungsanregung in ein Messsignal; und
- ein Schwingungsmessgerät aufweisend eine Elektrik zur Aufnahme und Wiedergabe des Messsignals.

Mit einer derartigen Messvorrichtung lässt sich nämlich vorteilhaft ein Magnetfeld erzeugen, indem die Erregerschleife durch den ferromagnetischen Hohlkörper hindurchgeführt wird und mit Wechselstrom und/oder Wechselspannung beaufschlagt wird. Die Amplitude der Schwingungsanregung wird gemessen indem der Schwingungsmessumformer am Gehäuse angebracht und ein Messsignal erzeugt wird, das in einem Schwingungsmessgerät aufgenommen und wiedergegeben wird.

Die im Zusammenhang mit dem Verfahren erläuterten Vorteile werden somit vor allem durch die Messvorrichtung gemäß dem neuen Konzept verwirklicht.

Vorteilhafterweise ist der Strom- und/oder Spannungsgenerator in Form eines Einphasen-Hochspannungsgenerators gebildet, der vorteilhaft frequenzvariabel ist. Die Erregerschleife ist vorzugsweise in Form einer Erregerwicklung mit mehreren Schleifen zur Bildung der Wicklung gebildet. Dies erhöht vorteilhaft die Amplitude des anregenden Magnetfeldes. Auf diese Weise lässt sich das Magnetfeld vorteilhaft frequenzvariabel bei unterschiedlichen Anregungsfrequenzen, vorzugsweise stufenlos zwischen 300 Hz und 600 Hz erzeugen.

Besonders bevorzugt lässt sich ein Schwingungsmessumformer in Form eines oder mehrerer piezoelektrischer Umformer mit je einem piezoelektrischen Sensor bilden. Derartige piezoelektrische Umformer erweisen sich als besonders sensitiv und kompakt.

Alternativ oder zusätzlich lässt sich ein Schwingungsmessumformer auch in Form eines oder mehrerer Schwingspulenmessumformer mit jeweils einem schwingungsfähig zueinander angeordneten Magneten und einer Spule bilden. Dies hat den Vorteil, dass besonders hohe Amplituden einer Schwingungsanregung erfasst werden können.

Vorzugsweise ist das Schwingungsmessgerät mehrkanalig ausgebildet, so dass die Signale von einem oder mehreren Schwingungsmessumformern empfangen und ggf. gleichzeitig dargestellt werden können.

Die Erfindung führt zur Lösung der Aufgabe des Weiteren auf ein Messsystem zur Charakterisierung von Schwingungsanregungen aufweisend eine Messvorrichtung der oben erläuterten Art und ein Turbogenerator-Ständerteil, aufweisend einen Gehäusemantel und ein in dem Gehäusemantel angeordnetes Ständeraktivteil, das einen ferromagnetischen Hohlkörper bildet.

Besonders bevorzugt ist der Hohlkörper in Form eines Hohlzylinders gebildet und weist dabei eine Anzahl von Ringsegmenten auf, wobei jeweils zwischen zwei benachbarten Ringsegmenten ein Grenzring gebildet ist. In der Regel weist der Hohlzylinder eine Anzahl von Achsen geringer Biegesteifigkeit auf. Üblicherweise weist nämlich ein ferromagnetischer Hohlzylinder eines Ständeraktivteils eine Vielzahl von Axialdurchführungen auf, wie beispielsweise Kühlgaskanäle, die zu axial angeordneten "weichen" Gehäusestellen führen, also Achsen geringer Biegesteifigkeit. Außerdem ist ein ferromagnetischer Hohlzylinder in der Regel aus mehreren "Schüssen" in Form von benachbarten Ringsegmenten gebildet, die axial hintereinander aneinander gefügt sind. Ein Grenzring ist dabei, insbesondere in Form Schweißnähten oder anderen Verbindungsringen, zwischen den Schüssen gebildet, die ebenfalls anfällig für Schwingungsanregungen sind.

Gemäß einer besonders bevorzugten Weiterbildung des Messsystems ist eine Anzahl von Schwingungsmessumformern entlang einer oder mehrerer Achsen geringer Biegesteifigkeit angeordnet. Vorzugsweise ist des Weiteren eine Anzahl von Schwingungsmessumformern in einem Abstand vor und/oder hinter einem Grenzring angeordnet. Eine derartige Anordnung einer Anzahl von Schwingungsmessumformern folgt letztlich dem Prinzip, dass ein Ständeraktivteil praktisch an allen sensiblen Stellen lokal aufgelöst hinsichtlich der Schwingungsanregung charakterisiert werden sollte.

In einer vollständig ausgebauten Weiterbildung des oben erläuterten Konzepts lässt sich also eine frequenzabhängige und phasenabhängige Charakterisierung der Schwingungsanregung in örtlicher Auflösung für praktisch das gesamte Ständeraktivteil und den Gehäusemantel erreichen. Mit Kenntnis der so ermittelten Eigenfrequenzen und -formen lassen sich gezielte Maßnahmen zum Verschieben der Eigenschwingungen aus dem Frequenzbereich der betrieblich Anregenden oder zur Bedämpfung, beispielsweise durch Versteifung oder Dämpfungselemente, ableiten.

Ausführungsbeispiele der Erfindung werden nachfolgend anhand der Zeichnung beschrieben. Diese soll die Ausführungsbeispiele nicht maßgeblich darstellen, vielmehr ist die Zeichnung, wo zur Erläuterung dienlich, in schematisierter und/oder leicht verzerrter Form ausgeführt. Im Hinblick auf Ergänzungen der aus der Zeichnung unmittelbar erkennbaren Lehren wird auf den einschlägigen Stand der Technik verwiesen. Im Einzelnen zeigt die Zeichnung in:
- FIG 1: eine perspektivische dreidimensionale prinzipielle Darstellung einer bevorzugten Ausführungsform eines Messsystems zur Charakterisierung von Schwingungsanregungen, aufweisend eine besonders bevorzugte Ausführungsform einer Messvorrichtung und ein Turbogenerator-Ständerteil;
- FIG 2: ein beispielhaftes Ergebnis einer messtechnischen Ermittlung des Frequenzgangs von Schwingungsanregungen eines Gehäuses bei einem Turbogenerator-Ständerteil entlang einer Anzahl von Überströmkanälen, die jeweils eine Achse geringer Biegesteifigkeit bilden;
- FIG 3: eine analog und unter gleichen Bedingungen wie in FIG 2 durchgeführte Vergleichsmessung nach dem Anbringen von Zusatzversteifungen im Bereich der Überströmkanäle.

FIG 1 zeigt eine besonders bevorzugte Ausführungsform eines Messsystems 1 aufweisend eine Messvorrichtung 3 und ein Turbogenerator-Ständerteil 5. Das Turbogenerator-Ständerteil 5 ist Teil eines Turbogenerators, der außer dem Ständerteil 5 üblicherweise einen hier nicht dargestellten, sich entlang der Achse 7 erstreckenden Läufer mit einer Läuferwicklung aufweist. Der entlang der Achse 7 angeordnete Läufer wird bei Betrieb durch eine Turbine in Rotation versetzt, was zu einem sich periodisch ändernden magnetischen Fluss in den Wicklungen des Ständerteils 5 führt. Das Magnetfeld wird dazu von der von Gleichstrom durchflossenen Läuferwicklung erzeugt. Das Ständerteil 5 weist einen Gehäusemantel 9, ein in dem Gehäusemantel 9 und in der vorliegenden Ausführungsform starr mit dem Gehäusemantel 9 verbundenes Ständeraktivteil 11 sowie ein Anschlussterminal 13 auf.

Das Ständeraktivteil 11 weist neben einer nicht im Detail dargestellten Ständerwicklung und Schaltleitungsanordnung vor allem ein zur Bildung eines ferromagnetischen Hohlkörpers 15 vorgesehenes Ständerblechpaket 17 auf, von dem der Blechpaketrücken in FIG 1 zu sehen ist. Dabei handelt es sich bei dem in FIG 1 beispielhaft dargestellten Ständerblechpaket 17 eines Turbogenerators größenordnungsmäßig um etwa 180.000 Bleche, die kreisringförmig zur Bildung des ferromagnetischen Hohlkörpers 15 angeordnet sind. Diese sind über als Führung dienende Schichtbalken 19 gehalten und befestigt. Weiters sind die Bleche durch umfänglich verlaufende Wicklungsstäbe 25 gehalten. Sowohl die Bleche des Ständerblechpakets 17 als auch der Gehäusemantel 9 ist größtenteils aus ferromagnetischen Baustoffen zur Bildung des ferromagnetischen Hohlzylinders 15 ausgeführt. Der zylindrische Hohlraum erstreckt sich im ferromagnetischen Hohlkörper 15 im Wesentlichen entlang der Achse 7, die üblicherweise bei vollständig fertig gestelltem Turbogenerator vom hier nicht dargestellten Läufer ausgefüllt wird. Ein Teil der Ständerwicklung ist in der perspektivischen Darstellung der FIG 1 mit dem Bezugszeichen 21 versehen. Ein Teil der Schaltleitungsanordnung ist in der perspektivischen Darstellung der FIG 1 mit dem Bezugszeichen 23 versehen. Das Bezugszeichen 23 weist auf elektrische Abschirmungen der Schaltstäbe einer Schaltleitungsanordnung für die Ständerwicklung.

Die in FIG 1 schematisch dargestellte Messvorrichtung 3 weist einen Strom- und/oder Spannungsgenerator 31 in Form eines frequenzvariabel einstellbaren Einphasen-Hochspannungsgenerators auf, sowie eine an den Generator 31 angeschlossene Erregerwicklung 33, die mit Wechselstrom beaufschlagt wird. Der Generator 31 erzeugt dabei einen 400 V-Dreiphasen-Wechselstrom, der jedem üblichen Drehstromnetz für Starkstrom entnehmbar ist. Der Generator 31 weist dazu vorteilhafterweise Bestandteile wie einen Gleichstromzwischenkreis, eine Spannungsweiche, einen Pulsweitenmodulator und einen Tiefpass auf.

Des Weiteren weist die Messvorrichtung 3 eine Anzahl von Schwingungsmessumformern 35 auf, von denen in FIG 1 drei beispielhaft dargestellt sind. Vorliegend handelt es sich dabei um piezoelektrische Umformer mit je einem piezoelektrischen Sensor. Eine Schwingungsanregung wird durch einen Schwingungsmessumformer 35 jeweils über eine Messleitung 37 einem mehrkanaligen Schwingungsmessgerät 39 zugeführt, das eine Elektrik zur Aufnahme und Wiedergabe des Messsignals hat.

Zur Messwertaufnahme wird bei der Charakterisierung von Schwingungsanregungen des Turbogenerator-Ständerteils 5 das fest im Gehäusemantel 9 eingebaute Ständeraktivteil 11 durch Einprägung eines in seiner Frequenz stufenlos einstellbaren Magnetfeldes aktiv zum gleichfrequenten Schwingen angeregt. Durch den in der Erregerwicklung 33 vom Generator 31 erzeugten Wechselstarkstrom wird nämlich ein die Erregerwicklung 33 durchsetzendes, sich wechselnd änderndes, dem Wechselstarkstrom proportionales magnetisches Wechselfeld erzeugt, das den ferromagnetischen Hohlkörper 15 aufgrund magnetischer Wechselwirkung schwingungsanregt und dabei insbesondere auf das Blechpaket 17 wirkt. Konstruktionsbedingt wird diese Schwingungsanregung auf das Gehäuse 9 übertragen. Zur Messung dieser Schwingung wird das Gehäuse 9 an ausgewählten Stellen mit den oben erläuterten Schwingungsmessumformern 35 bestückt. Vorliegend sind die Schwingungsmessumformer 35 entlang einer Achse 41 mit geringer Biegesteifigkeit angeordnet. Diese Achse 41 mit geringer Biegesteifigkeit ist vor allem durch die Anordnung eines Kühlgaskanals 43 zwischen Gehäuse 9 und Blechpaket 17 hervorgerufen. Eine derartige "weiche" Stelle ist deshalb besonders anfällig für Schwingungsanregungen. Dem wird vorliegend durch die Anordnung der Schwingungsmessumformer 35 entlang der Achse 41 mit geringer Biegesteifigkeit Rechnung getragen. Des Weiteren ist ein Messumformer 35 an einem hier nicht näher dargestellten Grenzring angeordnet. Ein Grenzring stellt die Stoßstelle zweier nicht näher dargestellter "Schüsse" dar, aus denen der ferromagnetische Hohlkörper 15 bzw. der Gehäusemantel 9 aufgebaut ist. Ein Grenzring kann in Form einer Schweißnaht oder auf andere Weise gebildet sein und stellt ebenfalls einen Verlauf geringer Biegesteifigkeit dar.

Durch eine aktive Variation der Anregungsfrequenz des Generators 31 in Form eines frequenzvariabel einstellbaren Einphasen-Hochspannungsgenerators wird bei Beibehaltung der Stärke der magnetischen Erregung der Frequenzgang der Schwingungsamplituden am Gehäusemantel 9 messtechnisch ermittelt, d. h. die Amplitude einer Schwingungsanregung wird in Abhängigkeit der Anregungsfrequenz des frequenzvariablen Magnetfeldes gemessen und dargestellt. Die Stärke der magnetischen Erregung wird insbesondere dadurch konstant gehalten, dass die Amperezahl des in der Erregerwicklung 33 fließenden Wechselstarkstroms als auch die Windungszahl der Erregerwicklung 33 konstant gehalten wird.

Darüber hinaus sind entlang des Umfangs 45 des Gehäusemantels 9 hier nicht dargestellte Schwingungsmessumformer zur Ermittlung der Phase einer Schwingungsanregung in Abhängigkeit der Anregungsfrequenz des frequenzvariablen Magnetfeldes angeordnet. Auf diese Weise lassen sich also nicht nur die Eigenfrequenzen sondern auch die Eigenformen der Schwingungsanregungen charakterisieren. Diese Eigenformen entlang des Umfangs des Gehäuses 9 werden im technischen Sinne auch als "Beulmoden" bezeichnet.

Mit Kenntnis der so ermittelten Eigenfrequenzen und Eigenformen lassen sich gezielte Maßnahmen zum Verschieben der Eigenschwingungen aus dem Frequenzbereich der betrieblich anregbaren Frequenzen, z. B. durch Dämpfung, erreichen. Dies kann beispielsweise durch eine Versteifung oder eine entsprechende Bedämpfung erreicht werden.

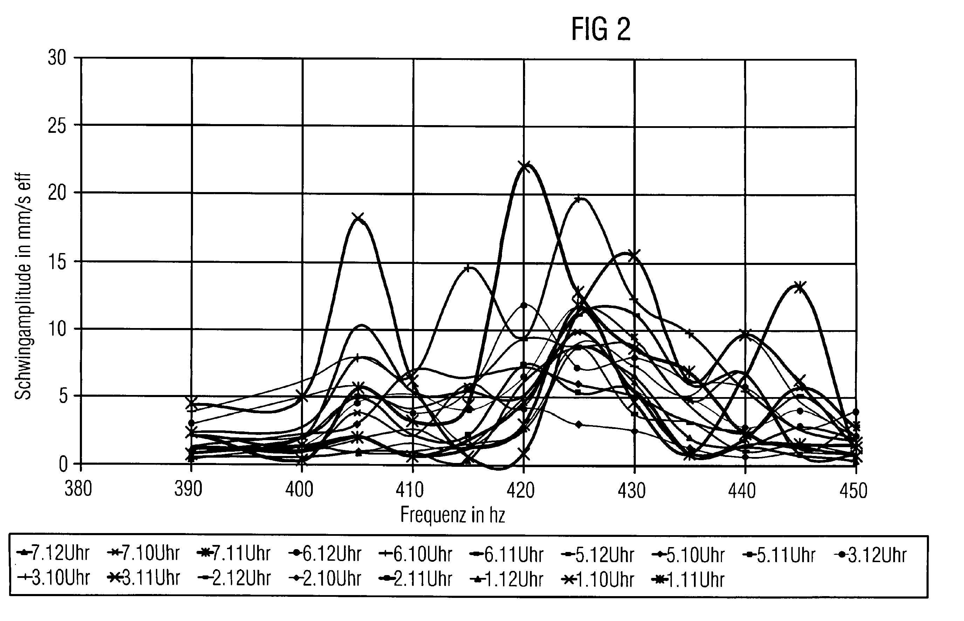

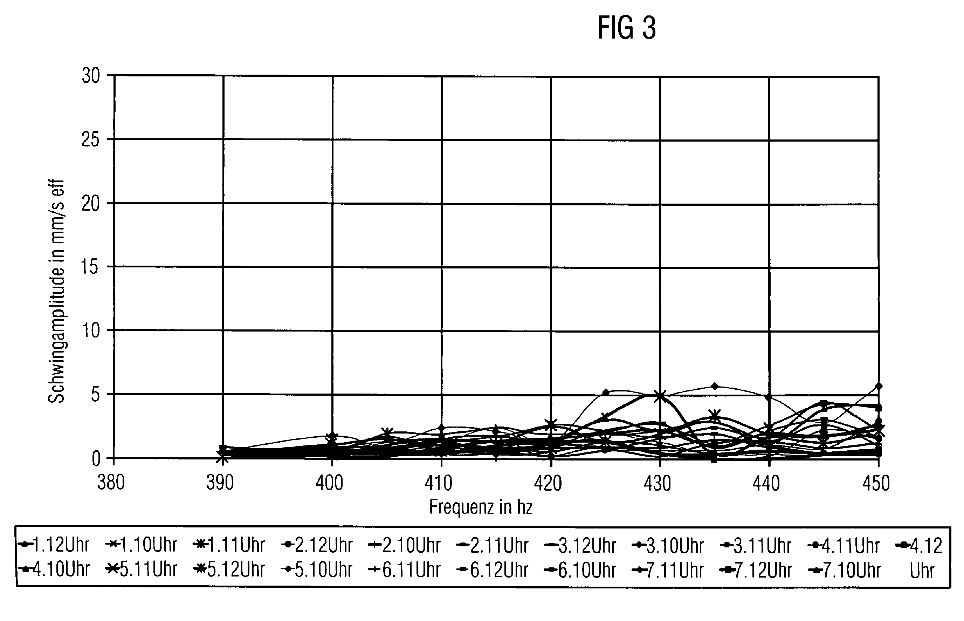

Ein Beispiel des Erfolgs einer solchen Maßnahme ist anhand des Vergleichs der FIG 2 und der FIG 3 ersichtlich, die im Folgenden erläutert werden.

FIG 2 zeigt den Frequenzgang von Gehäuseschwingungen für eine in FIG 1 dargestellte Auswahl von Überströmkanälen 43 entlang der Achse 41. Die Überströmkanäle 43 sind dabei durchnummeriert (7, 6, 5, 3, 2, 1) und zur Kennzeichnung ihrer Stellung entlang des Umfangs 45 des Gehäusemantels 9 mit einer Uhrzeit (12, 1, 11 Uhr) bezeichnet. Die effektive Schwingungsamplitude ist jeweils durch eine Kurve für einen Überströmkanal 43 in mm/s und in Abhängigkeit der Anregungsfrequenz des Magnetfeldes in Hz zwischen 380 Hz und 450 Hz dargestellt (die piezoelektrischen Sensoren an der Oberfläche des Gehäusemantels 9 liefern jeweils eine Geschwindigkeit als Messwert, aus dem sich die jeweilige Schwingungsamplitude unmittelbar durch Integration ergibt). Ohne auf die Kurven im Einzelnen einzugehen, ist in FIG 2 offensichtlich am Verlauf der Kurven deutlich zu erkennen, dass eine Vielzahl von starken Resonanzen vorhanden sind. Dabei dominieren insbesondere Frequenzen bei etwa 405 Hz, 420 Hz bis 430 Hz und um etwa 440 Hz bis 445 Hz. Die Anzahl, Größe und Stärke solcher dominierender Eigenfrequenzanteile und schwächerer Frequenzanteile als auch der detaillierte Verlauf des Frequenzgangs selbst ist dabei zum Teil jedenfalls von den speziellen konstruktiven Ausführungen eines individuellen Turbogenerator-Ständerteils 5 abhängig.

Nachdem über die in FIG 2 dargestellte Messerfassung des Frequenzgangs eine Schwingungsanregung hinsichtlich ihres Frequenzverlaufs (einzelne Kurve), hinsichtlich ihrer örtlichen Auflösung (verschiedene Kurven) als auch (hier nicht dargestellt) hinsichtlich ihres Phasenverlaufs charakterisiert wurde, ließ sich das Gehäuse 9 des Turbogenerator-Ständerteils 5 durch ein praktisch maßgeschneidertes Anbringen von Versteifungsrippen zusätzlich versteifen. Daraufhin wurde eine Vergleichsmessung unter den gleichen Bedingungen wie bei dem in FIG 2 dargestellten Ergebnis durchgeführt. Nach der Anbringung der Versteifungsrippen zeigt sich in FIG 3 praktisch keinerlei dominierende Eigenfrequenz mehr. Während praktisch entlang jedem Kühlgaskanal gemäß FIG 2 bei irgendeiner Frequenz zwischen 390 Hz und 450 Hz eine Schwingungsamplitude von mehr als 10 mm/s bis zum Teil oberhalb von 20 mm/s festzustellen war, lässt sich nunmehr anhand von FIG 3 belegen, dass alle Schwingungsamplituden entlang des gesamten Frequenzspektrums zwischen 390 Hz und 450 Hz praktisch unterhalb von 5 mm/s liegen, also in einem vernachlässigbaren Bereich.

Die angesprochene Versteifungsmaßnahme durch zusätzliches Anbringen von Versteifungsrippen am Gehäuse 9 ließ sich maßgeblich aufgrund der im Rahmen von FIG 1 erläuterten Messvorrichtung und des damit erläuterten Messverfahrens und dessen Ergebnis bedarfsgerecht durchführen. Der Erfolg ist aus dem Vergleich der Messergebnisse von FIG 2 und FIG 3 ersichtlich.

Zusammenfassend macht das neue Konzept eine messtechnische Ermittlung eines Frequenzgangs des Schwingungsverhaltens eines Turbogenerator-Ständerteils 5 sowohl in einem weiten Frequenzbereich als auch im Hinblick auf schwache Frequenzanteile möglich. Dazu sieht ein Messverfahren die Charakterisierung von Schwingungsanregungen eines Turbogenerator-Ständerteils 5 vor, das einen Gehäusemantel 9 und ein in dem Gehäusemantel 9 angeordnetes Ständeraktivteil 11 aufweist, das einen ferromagnetischen Hohlkörper 15 bildet. Gemäß dem neuen Konzept wird der ferromagnetische Hohlkörper 15 durch ein Magnetfeld schwingungsangeregt und eine Amplitude einer Schwingungsanregung wird am Gehäusemantel 9 gemessen. Dazu sind eine entsprechende Messvorrichtung 3 und ein Messsystem 1 angegeben.

## Patentansprüche

1. Messverfahren zur Charakterisierung von Schwingungsanregungen eines Turbogenerator-Ständerteils (5), aufweisend einen Gehäusemantel (9) und ein in dem Gehäusemantel (9) angeordnetes Ständeraktivteil (11), das einen ferromagnetischen Hohlkörper (15) bildet,
**dadurch gekennzeichnet, dass**
- der ferromagnetische Hohlkörper (15) durch ein Magnetfeld schwingungsangeregt wird; und
- eine Amplitude einer Schwingungsanregung am Gehäusemantel (9) gemessen wird.

2. Messverfahren nach Anspruch 1,
**dadurch gekennzeichnet, dass**
das Magnetfeld erzeugt wird, indem eine Erregerschleife (33) durch den ferromagnetischen Hohlkörper (15) hindurchgeführt wird und mit Wechselstrom beaufschlagt wird.

3. Messverfahren nach Anspruch 1 oder 2,
**dadurch gekennzeichnet, dass**
eine Amplitude einer Schwingungsanregung gemessen wird, indem ein Schwingungsmessumformer (35) am Gehäusemantel (9) angebracht wird und ein Messsignal erzeugt, das in einem Schwingungsmessgerät (39) aufgenommen und wiedergegeben wird.

4. Messverfahren nach einem der Ansprüche 1 bis 3,
**dadurch gekennzeichnet, dass**
das Magnetfeld frequenzvariabel bei unterschiedlichen Anregungsfrequenzen erzeugt wird.

5. Messverfahren nach einem der Ansprüche 1 bis 4,
**dadurch gekennzeichnet, dass**
das Magnetfeld frequenzvariabel bei unterschiedlichen Anregungsfrequenzen zwischen 300 Hz und 600 Hz erzeugt wird.

6. Messverfahren nach einem der Ansprüche 1 bis 5,
**dadurch gekennzeichnet, dass**
das Magnetfeld frequenzvariabel und stufenlos einstellbar bei unterschiedlichen Anregungsfrequenzen erzeugt wird.

7. Messverfahren nach einem der Ansprüche 1 bis 6,
**dadurch gekennzeichnet, dass**
eine Amplitude einer Schwingungsanregung in Abhängigkeit der Anregungsfrequenz des frequenzvariablen Magnetfeldes gemessen wird.

8. Messverfahren nach einem der Ansprüche 1 bis 7,
**dadurch gekennzeichnet, dass**
eine Amplitude einer Schwingungsanregung an Stellen geringer Biegesteifigkeit am Gehäusemantel (9) gemessen wird.

9. Messverfahren nach einem der Ansprüche 1 bis 8,
**dadurch gekennzeichnet, dass**
eine räumliche Phase einer Schwingungsanregung gemessen wird.

10. Messvorrichtung (3) zur Charakterisierung von Schwingungsanregungen eines Turbogenerator-Ständerteils (5), aufweisend einen Gehäusemantel (9) und ein in dem Gehäusemantel (9) angeordnetes Ständeraktivteil (11), das einen ferromagnetischen Hohlkörper (15) bildet,
**gekennzeichnet durch**
- einen Strom- und/oder Spannungsgenerator (31);
- eine an den Strom- und/oder Spannungsgenerator (31) anschließbare Erregerschleife (33) zur Beaufschlagung mit Wechselstrom und/oder Wechselspannung **durch** den Strom- und/oder Spannungsgenerator (31);
- einen Schwingungsmessumformer (35) aufweisend einen Sensor zur Aufnahme einer Schwingungsanregung und Mittel zur Umformung der Schwingungsanregung in ein Messsignal; und
- ein Schwingungsmessgerät (39) aufweisend eine Elektrik zur Aufnahme und Wiedergabe des Messsignals.

11. Messvorrichtung (3) nach Anspruch 10,
**dadurch gekennzeichnet, dass**
der Strom- und/oder Spannungsgenerator (31) in Form eines Einphasen-Hochspannungsgenerators gebildet ist.

12. Messvorrichtung (3) nach Anspruch 10 oder 11,
**dadurch gekennzeichnet, dass**
der Strom- und/oder Spannungsgenerator (31) frequenzvariabel ist.

13. Messvorrichtung (3) nach einem der Ansprüche 10 bis 12,
**dadurch gekennzeichnet, dass**
die Erregerschleife (33) in Form einer Erregerwicklung gebildet ist.

14. Messvorrichtung (3) nach einem der Ansprüche 10 bis 13,
**dadurch gekennzeichnet, dass**
der Schwingungsmessumformer (35) in Form eines oder mehrerer piezoelektrischer Umformer mit je einem piezoelektrischen Sensor gebildet ist.

15. Messvorrichtung (3) nach einem der Ansprüche 10 bis 14,
**dadurch gekennzeichnet, dass**
der Schwingungsmessumformer (35) in Form eines oder mehrerer Schwingspulenmessumformer mit jeweils einem schwingungsfähig zueinander angeordneten Magneten und einer Spule gebildet ist.

16. Messvorrichtung (3) nach einem der Ansprüche 10 bis 15,
**dadurch gekennzeichnet, dass**
das Schwingungsmessgerät (39) mehrkanalig ist.

17. Messsystem (1) zur Charakterisierung von Schwingungsanregungen aufweisend eine Messvorrichtung (3) nach Anspruch 9 und ein Turbogenerator-Ständerteil (5), aufweisend einen Gehäusemantel (9) und ein in dem Gehäusemantel (9) angeordnetes Ständeraktivteil (11), das einen ferromagnetischen Hohlkörper (15) bildet.

18. Messsystem (1) nach Anspruch 17,
**dadurch gekennzeichnet, dass**
der Hohlkörper (15) in Form eines Hohlzylinders gebildet ist, aufweisend eine Anzahl von Ringsegmenten, wobei jeweils zwischen zwei benachbarten Ringsegmenten ein Grenzring gebildet ist.

19. Messsystem nach Anspruch 17 oder 18,
**dadurch gekennzeichnet, dass**
eine Anzahl von Schwingungsmessumformern (35) entlang einer oder mehrerer Achsen (41) geringer Biegesteifigkeit angeordnet sind.

20. Messsystem (1) nach einem der Ansprüche 17 bis 19,
**dadurch gekennzeichnet, dass**
eine Anzahl von Schwingungsmessumformern (35) in einem Abstand vor und/oder hinter einem Grenzring angeordnet sind.
